# FASCICULE DE BREVET EUROPEEN

(11) **EP 3 698 020 B1**
(45) Date de publication et mention de la délivrance du brevet: **22.09.2021**
(21) Numéro de dépôt: 18808418.0
(22) Date de dépôt: 17.10.2018
(51) Int. Cl.: F01D 5/00, F01D 25/00

(54) **PIÈCE DE TURBINE EN SUPERALLIAGE COMPRENANT DU RHÉNIUM ET PROCÉDÉ DE FABRICATION ASSOCIÉ**
TURBINENBAUTEIL AUS SUPERLEGIERUNG MIT RHENIUM UND ZUGEHÖRIGES HERSTELLUNGSVERFAHREN
TURBINE COMPONENT MADE FROM SUPERALLOY COMPRISING RHENIUM AND ASSOCIATED MANUFACTURING PROCESS

(30) Priorité: 20.10.2017 FR 1701096
(43) Date de publication de la demande: 26.08.2020
(73) Titulaire: Safran, 75015 Paris (FR)
(72) Inventeur: SABOUNDJI, Amar, 77550 Moissy-Cramayel (FR); JAQUET, Virginie, 77550 Moissy-Cramayel (FR)
(74) Mandataire: Regimbeau
(86) Numéro de dépôt international: PCT/FR2018/052584
(87) Numéro de publication internationale: WO 2019/077271

(56) Documents cités:
- EP-A2- 1 939 318
- WO-A1-2012/146864
- US-A1- 2004 142 204
- US-A1- 2013 142 637
- US-A1- 2017 058 405
- US-B1- 6 461 746

## Description

### DOMAINE DE L'INVENTION

L'invention concerne une pièce de turbine, telle qu'une aube de turbine ou une ailette de distributeur par exemple, utilisée dans l'aéronautique.

### ETAT DE LA TECHNIQUE

Dans un turboréacteur, les gaz d'échappement générés par la chambre de combustion peuvent atteindre des températures élevées, supérieure à 1200°C, voire 1600°C. Les pièces du turboréacteur, en contact avec ces gaz d'échappement, telles que les aubes de turbine par exemple, doivent ainsi être capables de conserver leurs propriétés mécaniques à ces températures élevées.

A cet effet, il est connu de fabriquer certaines pièces du turboréacteur en « superalliage ». Les superalliages constituent une famille d'alliages métalliques à haute résistance pouvant travailler à des températures relativement proches de leurs points de fusion (typiquement 0,7 à 0,8 fois leurs températures de fusion).

Afin de renforcer la résistance thermique de ces superalliages et de les protéger contre l'oxydation et la corrosion, il est connu de les recouvrir d'un revêtement jouant un rôle de barrière thermique.

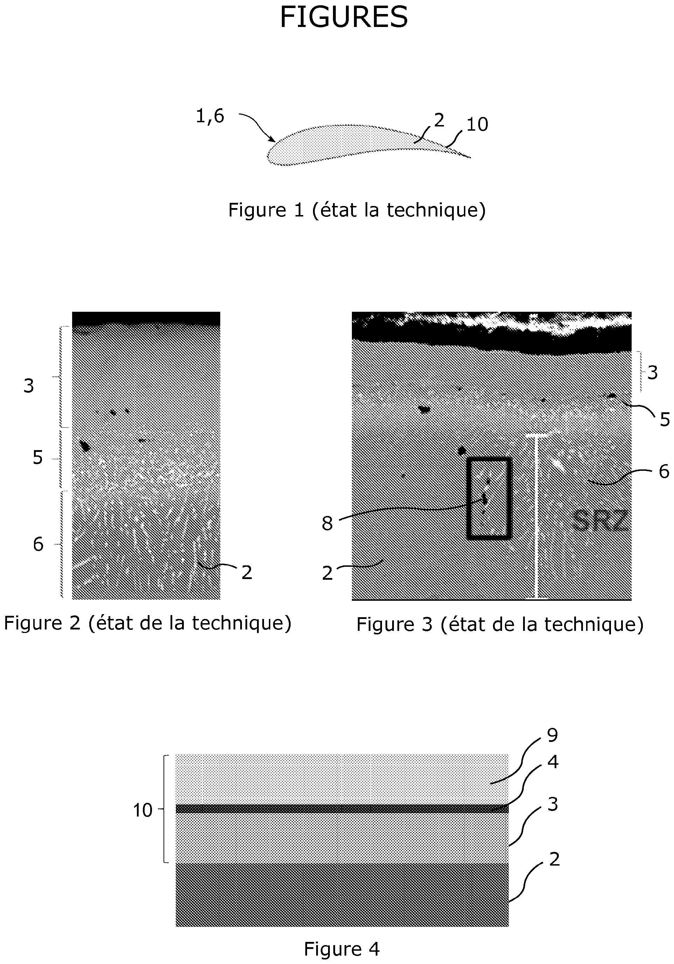

La figure 1 illustre schématiquement une section d'une pièce de turbine 1, par exemple une aube 6 de turbine ou une ailette de distributeur. La pièce 1 comprend un substrat 2 en superalliage métallique monocristallin recouvert d'une barrière thermique 10.

La barrière thermique 10 comprend typiquement une sous-couche métallique, une couche protectrice et une couche thermiquement isolante. La sous-couche métallique recouvre le substrat en superalliage métallique. La sous-couche métallique est elle-même recouverte de la couche protectrice, formée par oxydation de la sous-couche métallique. La couche protectrice permet de protéger le substrat en superalliage de la corrosion et/ou de l'oxydation. La couche thermiquement isolante recouvre la couche protectrice. La couche thermiquement isolante peut être en céramique, par exemple en zircone yttriée.

La sous-couche métallique assure une liaison entre la surface du substrat en superalliage et la couche protectrice : la sous-couche métallique est parfois appelée « sous-couche d'accroche ».

Une sous-couche peut être fabriquée à base d'aluminure de nickel simple β-NiAl ou modifié platine β-NiAlPt. La fraction massique moyenne en aluminium (comprise entre 0,35 et 0,45) de la sous-couche est suffisante pour former exclusivement une couche protectrice d'oxyde d'aluminium (Al₂O₃) permettant de protéger le substrat en superalliage contre l'oxydation et la corrosion.

Toutefois, lorsque la pièce est soumise à de hautes températures, la différence des concentrations en nickel, et surtout en aluminium, entre le substrat en superalliage et la sous-couche métallique entraîne une diffusion des différents éléments, en particulier du nickel du substrat vers la sous-couche métallique, et de l'aluminium de la sous-couche métallique vers le superalliage. Ce phénomène est appelé « inter-diffusion ».

L'inter-diffusion peut entraîner la formation de zones de réaction primaires et secondaires (appelées « SRZ » ou *Secondary Reaction Zone* en anglais) dans une partie du substrat en contact avec la sous-couche.

La figure 2 est une microphotographie de la section d'une sous-couche 3 recouvrant un substrat 2. La microphotographie est réalisée avant que la pièce ne soit soumise à une série de cycles thermiques permettant de simuler les conditions de travail en température de la pièce 1. Le substrat 2 est riche en rhénium, c'est-à-dire que la fraction massique moyenne en rhénium est supérieure à 0,04. Il est connu d'utiliser le rhénium dans la composition des superalliages pour augmenter la résistance au fluage des pièces en superalliage. Il est également connu d'utiliser des superalliages présentant une fraction massique moyenne en chrome basse, c'est-à-dire inférieure à 0,08 pour augmenter la tenue en oxydation et en corrosion de la structure lorsque le substrat est riche en rhénium. Typiquement, le substrat 2 présente une phase γ-γ' Ni. La sous-couche 3 est de type β-NiAlPt. Le substrat présente une zone d'inter-diffusion primaire 5, dans la partie du substrat 2 directement recouverte par la sous-couche 3. Le substrat 2 présente également une zone d'inter-diffusion secondaire 6, directement recouverte par la zone d'inter-diffusion primaire 5. L'épaisseur de la zone d'inter-diffusion secondaire illustrée sur la figure 2 est sensiblement de 35 µm et plus généralement comprise entre 20 et 50 µm.

La figure 3 est une microphotographie de la section de la sous-couche 3 recouvrant le substrat 2. La microphotographie présente la sous-couche 3 et le substrat 2 après les avoir soumis à la série de cycles thermiques décrite précédemment. La sous-couche 3 recouvre le substrat 2. Le substrat 2 présente une zone d'inter-diffusion primaire 5 et une zone d'inter-diffusion secondaire 6. Localement, l'épaisseur de la zone d'inter-diffusion secondaire peut être supérieure à 100 µm et peut atteindre 150 µm, comme représenté par le segment blanc sur la figure 3.

La combinaison d'un superalliage comprenant du rhénium, pauvre en chrome avec une sous-couche de type β-NiAlPt entraîne la formation de zones de réaction secondaires. La formation des zones de réaction secondaires dégrade fortement les propriétés mécaniques (fluage, fatigue) du superalliage en entraînant l'apparition de fissures 8 et/ou de contraintes mécanique élevée dans le substrat 2 en soumettant une pièce 1 à des conditions de températures élevées, par exemple supérieure à 1000°C.

Ainsi, les inter-diffusions entre le substrat en superalliage et la sous-couche peuvent avoir des conséquences néfastes sur la durée de vie de la pièce en superalliage.

On connait déjà d'après les documents US 6 461 746 et US 2004/142204 une pièce de turbine présentant les caractéristiques du préambule de la revendication 1. Toutefois, ces documents ne décrivent ni ne suggèrent le fait que la sous-couche en superalliage métallique base nickel présente majoritairement en volume une phase γ'-Ni₃Al, ni les effets bénéfiques que cela procure sur la limitation ou l'absence de formation de zones de réaction secondaires.

### RESUME DE L'INVENTION

Un but de l'invention est de proposer une solution pour protéger efficacement une pièce de turbine en superalliage de l'oxydation et de la corrosion tout en augmentant sa durée de vie, lors de son utilisation, par rapport aux pièces connues.

Ce but est atteint dans le cadre de la présente invention grâce à une pièce de turbine comprenant un substrat en superalliage base nickel monocristallin, comprenant du rhénium, présentant une phase γ-γ' Ni, et une fraction massique moyenne en chrome inférieure à 0,08, une sous-couche en superalliage métallique base nickel recouvrant le substrat, caractérisée en ce que la sous-couche en superalliage métallique comprend au moins de l'aluminium, du nickel, du chrome, du silicium, de l'hafnium et présente majoritairement en volume une phase γ'-Ni₃Al.

Comme la sous-couche métallique présente une structure allotropique proche de la structure du substrat, la formation de zones de réaction secondaires est empêchée et/ou limitée. Ainsi, la formation de fissures dans le substrat d'une pièce soumise à des conditions de températures élevées, par exemple supérieures à 1000°C ainsi que l'écaillage de la couche protectrice en oxyde d'aluminium sont limités ou empêchés.

De plus, comme la sous-couche métallique comprend de l'aluminium, tout en présentant majoritairement en masse une phase γ'-Ni₃Al, la sous-couche métallique peut être oxydée pour former une couche protectrice en aluminium pendant un temps plus long, en conditions de travail, qu'en utilisant les sous-couches métalliques connues.

La pièce de turbine peut en outre présenter les caractéristiques suivantes :
- la sous-couche présente également une phase γ-Ni ;
- la fraction massique moyenne en rhénium du substrat est supérieure à 0,04 ;
- la fraction massique moyenne en platine de la sous-couche est comprise entre 0 et 0,05 ;
- la fraction massique moyenne en aluminium de la sous-couche est comprise entre 0,06 et 0,25 ;
- la fraction massique moyenne en chrome de la sous-couche est comprise entre 0,07 et 0,20 ;
- la fraction massique moyenne en hafnium de la sous-couche est inférieure à 5% ;
- la fraction massique moyenne en silicium de la sous-couche est inférieure à 5% ;
- la sous-couche comprend en outre au moins un élément choisi parmi du cobalt, du molybdène, du tungstène, du titane et du tantale ;
- une couche protectrice en oxyde d'aluminium recouvre la sous-couche ;
- une couche thermiquement isolante en céramique recouvre la couche protectrice ;
- l'épaisseur de la sous-couche est comprise entre 5 µm et 50 µm.

L'invention concerne en outre procédé de fabrication d'une pièce de turbine comprenant une étape de dépôt sous vide d'une sous-couche d'un superalliage base nickel présentant majoritairement en volume une phase γ'-Ni₃Al, ainsi qu'éventuellement une phase γ-Ni, sur un substrat en superalliage base nickel comprenant du rhénium et présentant une phase γ-γ' Ni.

Le dépôt peut être mis en œuvre par une méthode choisie parmi un dépôt physique en phase vapeur, une projection thermique (par exemple par un système HVOF, acronyme anglais de *High Velocity Oxy-Fuel*), une évaporation joule, une ablation laser pulsée et une pulvérisation cathodique.

La sous-couche peut être déposée en co-pulvérisant et/ou en co-évaporant des cibles de matériaux métalliques différents.

### PRESENTATION DES DESSINS

D'autres caractéristiques et avantages ressortiront encore de la description qui suit, laquelle est purement illustrative et non limitative, et doit être lue en regard des figures annexées, parmi lesquelles :
- la figure 1 illustre schématiquement la section d'une pièce de turbine, par exemple une aube de turbine ou une ailette de distributeur ;
- la figure 2 est une microphotographie de la section d'une sous-couche recouvrant un substrat ;
- la figure 3 est une microphotographie de la section d'une sous-couche 3 recouvrant un substrat ;
- la figure 4 illustre schématiquement une section de barrière thermique recouvrant le substrat d'une pièce de turbine selon un mode de réalisation de l'invention.

### DEFINITIONS

On désigne par le terme « superalliage » un alliage complexe présentant, à haute température et à haute pression, une très bonne résistance à l'oxydation, à la corrosion, au fluage et à des contraintes cycliques (notamment mécaniques ou thermiques). Les superalliages trouvent une application particulière dans la fabrication de pièces utilisées dans l'aéronautique, par exemple des aubes de turbine, car ils constituent une famille d'alliages à haute résistance pouvant travailler à des températures relativement proches de leurs points de fusion (typiquement 0,7 à 0,8 fois leurs températures de fusion).

Un superalliage peut présenter une microstructure biphasique comprenant une première phase (appelée « phase γ ») formant une matrice, et une deuxième phase (appelée « phase y' ») formant des précipités durcissant dans la matrice.

La « base » du superalliage désigne le composant métallique principal de la matrice. Dans la majorité des cas, les superalliages comprennent une base fer, cobalt, ou nickel, mais également parfois une base titane ou aluminium.

Les « superalliages base nickel » présentent l'avantage d'offrir un bon compromis entre résistance à l'oxydation, résistance à la rupture à haute température et poids, ce qui justifie leur emploi dans les parties les plus chaudes des turboréacteurs.

Les superalliages base nickel sont constitués d'une phase y (ou matrice) de type austénitique cubique à face centrée γ-Ni, contenant éventuellement des additifs en solution solide de substitution α (Co, Cr, W, Mo), et d'une phase y' (ou précipités) de type γ'-Ni₃X, avec X = Al, Ti ou Ta. La phase y' possède une structure L₁₂ ordonnée, dérivée de la structure cubique à face centrée, cohérente avec la matrice, c'est-à-dire ayant une maille atomique très proche de celle-ci.

De par son caractère ordonné, la phase y' présente la propriété remarquable d'avoir une résistance mécanique qui augmente avec la température jusqu'à 800°C environ. La cohérence très forte entre les phases y et y' confère une tenue mécanique à chaud très élevée des superalliages à base nickel, qui dépend elle-même du ratio y/y' et de la taille des précipités durcissants.

Un superalliage est, dans l'ensemble des modes de réalisation de l'invention, riche en rhénium, c'est-à-dire que la fraction massique moyenne en rhénium du superalliage est supérieure à 0,04, permettant d'augmenter la résistance au fluage des pièces en superalliage comparativement aux pièces en superalliage sans rhénium. Un superalliage est également, dans l'ensemble des modes de réalisation de l'invention, pauvre en chrome, c'est-à-dire que la fraction massique moyenne en chrome est inférieure à 0,08, préférentiellement inférieure à 0,05, pour augmenter la tenue à l'oxydation de la structure lors de la présence de rhénium dans le superalliage.

Les superalliages base nickel présentent ainsi généralement une forte résistance mécanique jusqu'à 700°C, puis une résistance mécanique qui diminue fortement au-delà de 800°C.

Le terme « fraction massique » désigne le rapport de la masse d'un élément ou d'un groupe d'éléments sur la masse totale.

### DESCRIPTION DETAILLEE DE L'INVENTION

La figure 4 illustre schématiquement une section de barrière thermique 10 recouvrant le substrat 2 d'une pièce 1 de turbine conforme à un mode de réalisation de l'invention.

Les éléments illustrés en figure 4 peuvent être indépendamment représentatifs des éléments d'une aube 6 de turbine telle que celle qui est représentée sur la figure 1, d'une ailette de distributeur, ou de tout autre élément, partie ou pièce d'une turbine.

Le substrat 2 est formé en superalliage à base nickel. La fraction massique moyenne du substrat 2 en rhénium est supérieure à 0,04 et préférentiellement comprise entre 0,045 et 0,055. Préférentiellement, la fraction massique moyenne en chrome du substrat est basse, c'est-à-dire inférieure à 0,08 et préférentiellement inférieure à 0,05.

La barrière thermique 10 comprend une sous-couche métallique 3, une couche protectrice 4 et une couche thermiquement isolante 9.

Le substrat 2 est recouvert par la sous-couche 3 métallique. La sous-couche métallique 3 est recouverte par la couche protectrice 4. La couche protectrice 4 est recouverte par la couche thermiquement isolante 9.

Le dépôt d'une sous-couche 3 métallique présentant une structure allotropique proche de la structure du substrat 2 permet d'empêcher la formation de zones de réaction secondaires. En particulier, la sous-couche 3 déposée présente une phase y et une phase y', comme le substrat.

La sous-couche 3 présente une composition alumino-formeuse, permettant à la pièce de résister à l'oxydation et à la corrosion. En particulier, la sous-couche 3 présente majoritairement en volume une phase γ'-Ni₃Al. Préférentiellement, la sous-couche 3 présente également une phase γ-Ni. La sous-couche 3 présente ainsi à la fois une structure proche de la structure du substrat 2, tout en comprenant une réserve d'aluminium lui permettant de former une couche protectrice 4 en oxyde d'aluminium par oxydation, pendant plus de temps, comparativement à une sous-couche présentant une phase majoritaire γ-Ni dans laquelle la fraction massique en aluminium est plus petite. Préférentiellement, la fraction massique moyenne de la sous-couche 3 en aluminium est comprise entre 0,06 et 0,25 et préférentiellement entre 0,06 et 0,12.

Le tableau 1, ci-dessous, présente des exemples de compositions de la sous-couche 3 en superalliage base nickel. Les différentes compositions sont désignées par les lettres de A à C. Les fractions massiques, en pourcents, de la sous-couche 3 présentant une phase γ, et la fraction volumique de la sous-couche 3 présentant une phase γ', sont également décrites pour une sous-couche 3 ayant subi un traitement thermique à 1000° C.

**Tableau 1**

| | | | | | | | | | | | | 1000 °C | |
|---|---|---|---|---|---|---|---|---|---|---|---|---|---|
| | Ni | Co | Mo | Cr | W | Al | Ti | Ta | Pt | Hf | Si | %γ | %γ' |
| A | Base | | | 9-17 | | 6-12 | | | 0-5 | 0-5 | 0-5 | | |
| B | Base | | | 12 | | 9,5 | | | 0 | 1,7 | 0,6 | 15 | 85 |
| C | Base | | | 16 | | 7,8 | | | 0 | 1,7 | 1,5 | 40 | 60 |

La composition A correspond à une sous-couche 3 de type NiCrAlHfSiPt et présente une phase majoritaire γ'-Ni₃Al et une phase γ-Ni. La composition B correspond à une sous-couche 3 de type NiCrAlHfSi et présente une phase majoritaire γ'-Ni₃Al et préférentiellement une phase γ-Ni. Pour une sous-couche 3 ayant subi un traitement thermique à 1100°C, la fraction massique de la sous-couche 3 présentant une phase y est de 40 %m et la fraction massique de la sous-couche 3 présentant une phase y' est de 60 %m. La composition C correspond à une sous-couche 3 de type NiCrAlHfSi et présente une phase majoritaire γ'-Ni₃Al et une phase γ-Ni.

De manière générale, la sous-couche 3 présente préférentiellement une fraction massique moyenne en platine inférieure à 0,02 et/ou une fraction massique moyenne en chrome comprise entre 0,07 et 0,17. Ainsi, la tenue à l'oxydation de la pièce est augmentée.

La sous-couche 3 peut être déposée sous vide, par exemple en phase vapeur (procédé de PVD, acronyme du terme anglais *Physical Vapor Deposition).* Différentes méthodes de PVD peuvent être utilisées pour la fabrication de la sous-couche 3 telles que la pulvérisation cathodique, l'évaporation joule, l'ablation laser et le dépôt physique en phase vapeur assisté par faisceau d'électrons. La sous-couche 3 peut également être déposée par projection thermique.

Ainsi, la sous-couche 3 peut être déposée sur le substrat 2 sans utiliser une méthode de formation de sous-couche par diffusion d'éléments chimiques dans le substrat 2, comme le platine. Ces méthodes de dépôt permettent également une simplification de la formation de la sous-couche 3 sur le substrat 2 ainsi qu'un meilleur contrôle des compositions chimiques de la sous-couche 3. Elles permettent également de déposer une sous-couche 3 présentant majoritairement en volume une phase γ'-Ni3Al, ainsi qu'éventuellement une phase γ-Ni, contrairement aux méthodes connues.

Plusieurs cibles de matériaux métalliques différents peuvent être utilisées en parallèle, de manière simultanée, lors du dépôt d'une sous-couche 3. Ce type de dépôt peut être réalisé par co-évaporation ou par co-pulvérisation : la vitesse, respectivement d'évaporation, ou de pulvérisation imposée à chaque cible lors du dépôt de la sous-couche 3 détermine alors la stœchiométrie de ladite couche.

## Revendications

1. Pièce (1) de turbine comprenant :
- un substrat (2) en superalliage base nickel monocristallin, comprenant du rhénium, présentant une phase γ-γ' Ni, et une fraction massique moyenne en chrome inférieure à 0,08 ;
- une sous-couche (3) en superalliage métallique base nickel recouvrant le substrat (2), cette sous-couche comprenant au moins de l'aluminium, du nickel, du chrome, du silicium et de l'hafnium ;
**caractérisée en ce que** :
- la sous-couche (3) en superalliage métallique présente majoritairement en volume une phase γ'-Ni₃Al.

2. Pièce selon la revendication 1, dans laquelle la sous-couche (3) présente également une phase γ-Ni.

3. Pièce selon la revendication 1 ou 2, dans laquelle la fraction massique moyenne en rhénium du substrat (2) est supérieure à 0,04.

4. Pièce selon l'une des revendications 1 à 3, dans laquelle la fraction massique moyenne en platine de la sous-couche (3) est inférieure à 0,05.

5. Pièce selon l'une des revendications 1 à 4, dans laquelle la fraction massique moyenne en aluminium de la sous-couche (3) est comprise entre 0,06 et 0,25.

6. Pièce selon l'une des revendications 1 à 5, dans laquelle la fraction massique moyenne en chrome de la sous-couche (3) est comprise entre 0,07 et 0,20.

7. Pièce selon l'une des revendications 1 à 6, dans laquelle la fraction massique moyenne en hafnium de la sous-couche (3) est inférieure à 5%.

8. Pièce selon l'une des revendications 1 à 7, dans laquelle la fraction massique moyenne en silicium de la sous-couche (3) est inférieure à 5%.

9. Pièce selon l'une des revendications 1 à 8, dans laquelle la sous-couche (3) comprend en outre au moins un élément choisi parmi du cobalt, du molybdène, du tungstène, du titane, du tantale.

10. Pièce selon l'une des revendications 1 à 9, comprenant une couche protectrice (4) en oxyde d'aluminium recouvrant la sous-couche (3).

11. Pièce selon la revendication 10, comprenant une couche thermiquement isolante (9) en céramique recouvrant la couche protectrice (4).

12. Pièce selon l'une des revendications 1 à 11, dans laquelle l'épaisseur de la sous-couche (3) est comprise entre 5 µm et 50 µm.

13. Procédé de fabrication d'une pièce de turbine (1) comprenant une étape de dépôt sous vide d'une sous-couche (3) d'un superalliage base nickel présentant majoritairement en volume une phase γ'-Ni₃Al, ainsi qu'éventuellement une phase γ-Ni, sur un substrat (2) en superalliage base nickel comprenant du rhénium et présentant une phase γ-γ' Ni.

14. Procédé selon la revendication 13, dans lequel le dépôt est mis en œuvre par une méthode choisie parmi un dépôt physique en phase vapeur, une projection thermique, une évaporation joule, une ablation laser pulsée et une pulvérisation cathodique.

15. Procédé selon la revendication 13 ou 14, dans lequel la sous-couche (3) est déposée en co-pulvérisant et/ou en co-évaporant des cibles de matériaux métalliques différents.

## Patentansprüche

1. Turbinenbauteil (1), das umfasst:
- ein Substrat (2) aus Superlegierung auf Basis von monokristallinem Nickel, die Rhenium umfasst, eine γ-γ'-Ni-Phase und einem mittleren Massenanteil an Chrom von niedriger als 0,08 aufweist;
- eine Unterschicht (3) aus metallischer Superlegierung auf Nickel-Basis, die das Substrat (2) bedeckt, wobei diese Unterschicht mindestens Aluminium, Nickel, Chrom, Silizium und Hafnium umfasst;
**dadurch gekennzeichnet, dass**:
- die Unterschicht (3) aus metallischer Superlegierung im Volumen vorwiegend eine γ'-Ni₃Al-Phase aufweist.

2. Bauteil nach Anspruch 1, wobei die Unterschicht (3) auch eine γ-Ni-Phase aufweist.

3. Bauteil nach Anspruch 1 oder 2, wobei der mittlere Massenanteil an Rhenium des Substrats (2) höher als 0,04 ist.

4. Bauteil nach einem der Ansprüche 1 bis 3, wobei der mittlere Massenanteil an Platin der Unterschicht (3) niedriger als 0,05 ist.

5. Bauteil nach einem der Ansprüche 1 bis 4, wobei der mittlere Massenanteil an Aluminium der Unterschicht (3) zwischen 0,06 und 0,25 beträgt.

6. Bauteil nach einem der Ansprüche 1 bis 5, wobei der mittlere Massenanteil an Chrom der Unterschicht (3) zwischen 0,07 und 0,20 beträgt.

7. Bauteil nach einem der Ansprüche 1 bis 6, wobei der mittlere Massenanteil an Hafnium der Unterschicht (3) niedriger als 5% ist.

8. Bauteil nach einem der Ansprüche 1 bis 7, wobei der mittlere Massenanteil an Silizium der Unterschicht (3) niedriger als 5% ist.

9. Bauteil nach einem der Ansprüche 1 bis 8, wobei die Unterschicht (3) ferner mindestens ein Element umfasst, das aus Kobalt, Molybdän, Wolfram, Titan, Tantal ausgewählt ist.

10. Bauteil nach einem der Ansprüche 1 bis 9, das eine Schutzschicht (4) aus Aluminiumoxid umfasst, die die Unterschicht (3) bedeckt.

11. Bauteil nach Anspruch 10, das eine wärmeisolierende Schicht (9) aus Keramik umfasst, die die Schutzschicht (4) bedeckt.

12. Bauteil nach einem der Ansprüche 1 bis 11, wobei die Dicke der Unterschicht (3) zwischen 5 µm und 50 µm beträgt.

13. Verfahren zur Herstellung eines Turbinenbauteils (1), das einen Schritt zum Vakuum-Abscheiden einer Unterschicht (3) aus Superlegierung auf Nickelbasis, die im Volumen vorwiegend eine γ'-Ni₃Al-Phase sowie gegebenenfalls eine γ-Ni-Phase aufweist, auf einem Substrat (2) aus Superlegierung auf Nickelbasis, die Rhenium umfasst, und eine γ-γ'-Ni-Phase aufweist.

14. Verfahren nach Anspruch 13, wobei das Abscheiden durch ein Verfahren durchgeführt wird, das ausgewählt wird aus einer physikalischen Gasphasenabscheidung, einem thermischen Spritzen, einer Joule-Verdampfung, einem Laserstrahlverdampfen und einer Kathodenzerstäubung.

15. Verfahren nach Anspruch 13 oder 14, wobei die Unterschicht (3) durch gemeinsames Zerstäuben und/oder gemeinsames Verdampfen der verschiedenen Metallmaterialziele abgeschieden wird.

## Claims

1. A turbine component (1) comprising:
- a substrate (2) of single-crystal nickel-based superalloy, comprising rhenium, having a γ-γ' Ni phase, and an average chromium mass fraction of less than 0.08;
- a nickel-based metal superalloy sublayer (3) covering the substrate (2), this sublayer comprising at least aluminum, nickel, chromium, silicon, hafnium;
**characterized in that**:
- the metal superalloy sublayer (3) has a γ'-Ni₃Al phase predominantly by volume

2. The component as claimed in claim 1, wherein the sublayer (3) also has a γ-Ni phase.

3. The component as claimed in claim 1 or 2, wherein the average rhenium mass fraction of the substrate (2) is greater than 0.04.

4. The component as claimed in one of claims 1 to 3, wherein the average platinum mass fraction of the sublayer (3) is less than 0.05.

5. The component as claimed in one of claims 1 to 4, wherein the average aluminum mass fraction of the sublayer (3) is between 0.06 and 0.25.

6. The component as claimed in one of claims 1 to 5, wherein the average chromium mass fraction of the sublayer (3) is between 0.07 and 0.20.

7. The component as claimed in one of claims 1 to 6, wherein the average hafnium mass fraction of the sublayer (3) is less than 5%.

8. The component as claimed in one of claims 1 to 7, wherein the average silicon mass fraction of the sublayer (3) is less than 5%.

9. The component as claimed in one of claims 1 to 8, wherein the sublayer (3) further comprises at least one element selected from cobalt, molybdenum, tungsten, titanium, tantalum.

10. The component as claimed in one of claims 1 to 9, comprising an aluminum oxide protective layer (4) covering the sublayer (3).

11. The component as claimed in claim 10, comprising a thermally insulating ceramic layer (9) covering the protective layer (4).

12. The component as claimed in one of claims 1 to 11, wherein the thickness of the sublayer (3) is between 5 µm and 50 µm.

13. A process for manufacturing a turbine component (1) comprising a step of vacuum deposition of a sublayer (3) of a nickel-based superalloy having, predominantly in volume, a γ'-Ni₃Al phase, as well as optionally a γ-Ni phase, on a substrate (2) of nickel-based superalloy comprising rhenium and having a γ-γ' Ni phase.

14. The process as claimed in claim 13, wherein the deposition is carried out by a method selected from physical vapor deposition, thermal spraying, joule evaporation, pulsed laser ablation and sputtering.

15. The process as claimed in claim 13 or 14, wherein the sublayer (3) is deposited by co-spraying and/or co-evaporating targets of different metallic materials.
